# EUROPEAN PATENT SPECIFICATION

(11) **EP 0 315 385 B1**
(45) Date of publication and mention of the grant of the patent: **13.04.1994**
(21) Application number: 88310186.7
(22) Date of filing: 28.10.1988
(51) Int. Cl.: G11C 19/18, H03K 5/13

(54) **Delay circuits for integrated circuits**
Verzögerungsschaltungen für integrierte Schaltungen
Circuits de retard pour circuits intégrés

(30) Priority: 31.10.1987 JP 276874/87
(43) Date of publication of application: 10.05.1989
(73) Proprietor: SONY CORPORATION, Tokyo 141 (JP)
(72) Inventor: Usuki, Hideki c/o Patents Division, Shinagawa-ku Tokyo 141 (JP); Kohri, Shumpei c/o Patents Division, Shinagawa-ku Tokyo 141 (JP); Yano, Masatoshi c/o Patents Division, Shinagawa-ku Tokyo 141 (JP); Ishida, Hiroshi c/o Patents Division, Shinagawa-ku Tokyo 141 (JP)
(74) Representative: Pilch, Adam John Michael

(56) References cited:
- EP-A- 0 236 525
- US-A- 4 122 361
- US-A- 4 302 691

## Description

This invention relates to delay circuits for producing predetermined delay times and, in particular, to delay circuits for integrated circuits, such as complementary metal-oxide semiconductor (CMOS) circuits.

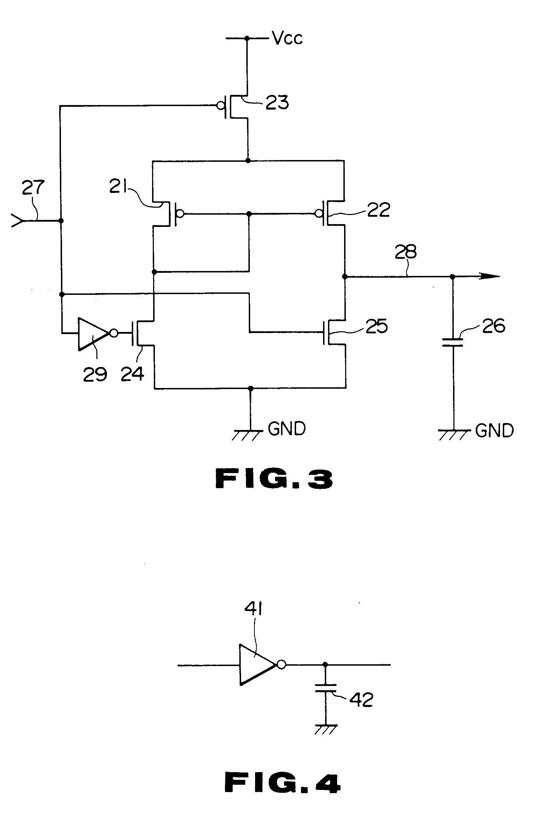

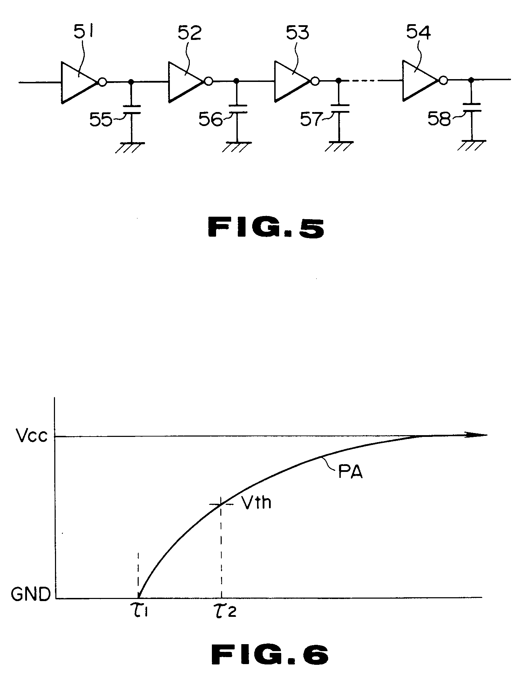

In certain types of memory device, data signals are latched at the output when address signals are applied, and then the memory cells are in a stand-by state for reducing the power consumption. This is sometimes known as a pulsed word line (PWL) system. In such memory devices, a delay circuit has to be used since a time delay of one cycle may be needed. Figures 4 and 5 of the accompanying drawings show examples of previously-proposed delay circuits. Figure 4 shows the basic construction of a delay circuit in which a capacitance 42, such as a metal-oxide semiconductor (MOS) capacitor, is connected to the output side of an inverter circuit 41. Figure 5 shows a circuit for obtaining a long delay time. The circuit has a plurality of inverter circuits 51 to 54, and capacitors 55 to 58 are provided between the inverter circuits. In this type of delay circuit, the input/output inverting operation is performed when the threshold voltage is exceeded so that the capacitors are charged gradually. A similar operation takes place when the voltage value at the capacitor exceeds the threshold voltage of the next stage inverter circuit. Figure 6 of the accompanying drawing is a waveform diagram showing output signals from such a delay circuit using one or more inverter circuits. When the inverter circuit is formed by a CMOS inverter, a waveform PA is obtained. The waveform PA starts to rise at a time τ1 and exceeds the threshold voltage Vth at a time τ2. At this time, the waveform PA presents an upwardly convex curve due to the drive capability of a PMOS (p-channel MOS) transistor forming part of the inverter circuit, such that the voltage approaches the source voltage Vcc gradually.

However, the above delay circuit is vulnerable to fluctuations in manufacturing parameters. For example, when the channel length of the transistor making up the inverter circuit changes, the threshold voltage Vth is charged, with a resulting increase or decrease in the delay time. When a longer delay time is desired, the number of stages has to be increased correspondingly. The result is that the occupation area is increased in an amount corresponding to the increased number of circuits, such as the inverter circuits. The delay time is set to be the time between τ1 and τ2 (namely τ2 - τ1) in Figure 6 as the reference. However, the waveform PA rises exponentially and thus it is difficult to set the delay time precisely.

EP-A-0 236 525 discloses a MOSFET integrated delay line in which a staged current mirror circuit is used to charge or discharge the input capacitance of the succeeding stage. Each stage of the circuit provides the same current value which can be adjusted by varying a mirrored reference current.

According to this invention there is provided a delay circuit for producing a predetermined delay time for an integrated circuit, the delay circuit comprising:
a current mirror circuit including at least a pair of current mirror connected MIS transistors;
a constant current source connected in the current path of one of the MIS transistors;
a capacitance connected to the other of the MIS transistors, so as to be charged by current flowing in the other MIS transistor; and
means for discharging the capacitance, the discharging means being switchable on by an input signal at a first of two states;
whereby the delay time of the delay circuit is determined by the charging time of the capacitance, characterised by the constant current source being switchable on by the input signal at a second of the two states.

A preferred embodiment of this invention, to be described in greater detail hereinafter, provides a delay circuit having a stable delay time which can be extended without complexity in the circuit. The preferred delay circuit also reduces the occupation area.

According to the preferred embodiment, the delay circuit is provided in a complementary MIS structure, in the form of a pair of current mirror connected MIS transistors. The current for charging the capacitance is dependent on the ratio of the current capability (channel conductance) of the pair of MIS transistors.

The invention will now be described by way of example with reference to the accompanying drawings, in which:
Figure 1 is a circuit diagram showing a delay circuit according to one embodiment of the present invention;
Figure 2 is a waveform diagram showing the output signals in the circuit of Figure 1;
Figure 3 is a circuit diagram showing a delay circuit according to another embodiment of the present invention;
Figure 4 is a circuit diagram showing an example of a previously-proposed delay circuit;
Figure 5 is a circuit diagram showing another example of a previously-proposed delay circuit; and
Figure 6 is a waveform diagram showing output signals from a previously-proposed delay circuit.

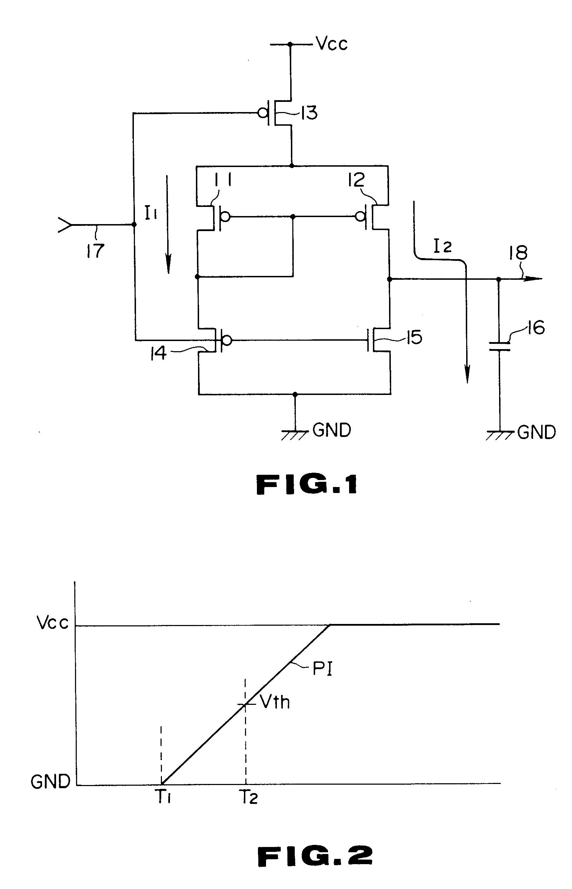

The first embodiment of the invention has a circuit construction as shown in Figure 1. A pair of PMOS transistors 11, 12 are connected in a common gate configuration so as to constitute a current mirror circuit. The common connected gates are also connected to the drain side of the PMOS transistor 11. The respective sources of the PMOS transistors 11, 12 are connected to a PMOS transistor 13 connected in common and acting as a switch. The transistor 13 has its source connected to a source voltage Vcc. A PMOS transistor 14 acting as a constant current source is connected to the drain of the PMOS transistor 11. The PMOS transistor 14 has its drain connected to earth or ground GND, and input signals are supplied to its gate via an input 17. The PMOS transistor 12 has its drain connected to a capacitor 16 for storing electrical charge and to an NMOS (n-channel MOS) transistor 15 for controlling the charging and discharging of the capacitor 16. The NMOS transistor 15 has its gate connected in common with the gate of the PMOS transistor 14, and to the input 17. The NMOS transistor 15 has its source connected to ground GND. The electrode of the capacitor 16 connected to the drain of the PMOS transistor 12 is also connected to an output 18. The other electrode of the capacitor 16 is connected to ground GND.

In the first embodiment, the PMOS transistor 13 may be dispensed with. The capacitor 16 may instead be a gate capacity of an MOS transistor.

The delay circuit of the first embodiment shown in Figure 1 operates in the following manner. The input signal at the input 17 is initially set to "H" (high) level. At this time, the PMOS transistors 13, 14 are both turned off. The NMOS transistor 15 is simultaneously turned on. The capacitor 16 has both its ends connected to the ground voltage and is reset. Therefore, the output signal from the delay circuit at the output 18 is a "L" (low) level. The input signal is then changed from the "H" to the "L" level. This causes the NMOS transistor 15 to be turned off and both the PMOS transistors 13, 14 to be turned on. With the PMOS transistors 13, 14 both turned on, a current I1 flows in the PMOS transistors 13, 11 and 14. This current I1 is determined by the PMOS transistor 14 acting as the constant current source, and more specifically by the level of the threshold voltage Vth of the PMOS transistor 14 and other parameters. The current I1 flowing in the PMOS transistor 11 also determines a current 12 of the PMOS transistor 12, since the PMOS transistors 11 and 12 are connected in a current mirror configuration. The value of the current I2 is given by the formula:

$\text{I2 = I1 x (Q2/Q1) (1)}$

(where Q2 and Q1 are the current capabilities of the PMOS transistors 12 and 11, respectively).

The current I2 flowing in the PMOS transistor 12 and having its value determined by the PMOS transistors 11, 13 flows into the capacitor 16, since the NMOS transistor 15 is turned off. The current I2 charging the capacitor 16 shows a constant current value and gives a constant charging time.

Figure 2 shows the voltage rise in the capacitor 16 caused by the current 12, that is, the waveform PI of the output 18. In Figure 2, the waveform PI rises substantially linearly from a time T1, and exceeds the next stage threshold voltage Vth at a time T2. When the next stage threshold voltage Vth is exceeded, output signals are obtained from the delay circuit which are delayed with respect to the input signals. Further similar delay circuit stages may be provided as the following stages and a waveform shaping circuit may also be provided.

In the delay circuit of the first embodiment, in order that the PMOS transistor 14 may operate ideally as a constant current source, it suffices that the current capability Q1 of the PMOS transistor 11 be sufficiently larger than the current capability Q3 of the PMOS transistor 14. For obtaining a long delay time, since it is necessary that a low current should flow in the PMOS transistor 12, it suffices that the current capability of the PMOS transistor 11 be sufficiently larger than that of the PMOS transistor 12. These current capabilities Q1 to Q3 are determined by manufacturing parameters (such as channel lengths and widths, concentration of impurities, and the like) and thus these parameters, if changed for manufacturing reasons, will be changed uniformly. Therefore, the ratio of the current capabilities will not be affected by manufacturing fluctuations. Therefore, the delay circuit is not vulnerable to manufacturing fluctuations. For example, fluctuations in the current I1 are suppressed by increasing the channel length of the PMOS transistor 14. Since the relationship between the PMOS transistors 11 and 12 is kept constant, the delay time of the delay circuit of the first embodiment is not affected by fluctuations in the channel length. In the delay circuit of the first embodiment, as shown in Figure 2, since the output signals are changed substantially linearly, the delay time can be set easily. That is, the time difference between the time T2 and the time T1 can be set with less error as compared with the previously-proposed exponential type circuit (see Figure 6). Thus a stable delay time can be achieved. Longer delay times can also be obtained by increasing the capacitance of the capacitor 16. However, a longer delay time can alternatively be obtained easily by setting the ratio between the current capabilities Q1 and Q2 so as to be larger. Hence, an extremely small capacitor 16 will suffice and the occupation area can therefore be reduced.

In the delay circuit of the second embodiment, the constant current source is constituted by an NMOS transistor to elevate the NMOS transistor dependency of the circuit.

The delay circuit of the second embodiment has a structure as shown in Figure 3. In a similar manner to the delay circuit of the first embodiment, a pair of PMOS transistors 21 and 22 are connected in a common gate configuration so as to constitute a current mirror circuit. The common connected gates are also connected to the drain side of the PMOS transistor 21. The paired PMOS transistors 21 and 22 have their sources connected in common and to a PMOS transistor 23 acting as a switch. The PMOS transistor 23 has its source connected to a source voltage Vcc. An NMOS transistor 24 acting as a constant current source is connected to a drain of the PMOS transistor 21. The NMOS transistor 24 has its source connected to ground GND and input signals are supplied from an input 27 via an inverter circuit 29. An NMOS transistor 25 for controlling the charging and discharging of a capacitor 26 is connected to the drain of the PMOS transistor 22. Input signals are applied to the gate of the NMOS transistor 25 from the input 27. The source of the NMOS transistor 25 is connected to ground GND. The electrode of the capacitor 26 connected to the drain side of the PMOS transistor 22 is also connected to an output 28 supplying output signals. The other electrode of the capacitor 26 is connected to ground GND.

In the second embodiment, the PMOS transistor 23 may be dispensed with. The capacitor 26 may be the gate capacity of an MOS transistor.

The operation of the delay circuit of the second embodiment is substantially similar to that of the delay circuit of the first embodiment, the only difference being that the NMOS transistor 24 is used as the constant current source MOS transistor.

When the input signal is changed from "H" level to "L" level, the NMOS transistor 25 is turned from the on state to the off state, for releasing the reset state of the capacitor 26. Simultaneously, the NMOS transistor 24 is turned to the on state from the off state. The current value I1' of the PMOS transistor 21 can be determined by arranging the current capability Q3' of the NMOS transistor 24 to be substantially lower than the current capability Q1' of the PMOS transistor 21. The relation expressed by the equation (1) in the first embodiment also holds between the current mirror connected PMOS transistors 21 and 22. Therefore, the level of the current flowing into the capacitor 26 is determined by the NMOS transistor 24. In general, numerous NMOS transistors are formed in each memory cell and these represent the main factors in determining the operational timing. Therefore, the NMOS transistor dependency of the circuit may be increased using the NMOS transistor 24 as the constant current source. For example, when the NMOS transistor is slightly faster than the design value, this tendency is reflected in the delay circuit. In similar manner to the delay circuit of the first embodiment, the manufacturing parameters, if changed, will be changed uniformly for the delay circuit of the second embodiment, so that the ratio of the current capabilities is not affected by manufacturing fluctuations. An output as shown in Figure 2 may be obtained in the delay circuit of the second embodiment, and the transition is substantially linear so that error is minimised and a stable delay time may be obtained. If desired, a long delay time can be obtained by selecting the capacitance of the capacitor 26 to be larger; however, a longer delay time can be obtained easily by reducing the current value I1' based on the constant current source or selecting a suitable ratio for the current capabilities of the current mirror PMOS transistors 21 and 22. In this manner, the occupation area of the capacitor 26 can be significantly reduced.

It is to be noted that a number of delay circuit stages may be connected in the delay circuit according to the previously-described embodiments.

## Claims

1. A delay circuit for producing a predetermined delay time for an integrated circuit, the delay circuit comprising:
a current mirror circuit including at least a pair of current mirror connected MIS transistors (11, 12; 21, 22);
a constant current source (14; 24) connected in the current path of one (11; 21) of the MIS transistors;
a capacitance (16; 26) connected to the other (12; 22) of the MIS transistors, so as to be charged by current flowing in the other MIS transistor (12; 22); and
means (15; 25) for discharging the capacitance (16; 26), the discharging means being switchable on by an input signal at a first of two states;
whereby the delay time of the delay circuit is determined by the charging time of the capacitance (16; 26),
characterised by the constant current source (14; 24) being switchable on by the input signal at a second of the two states.

2. A delay circuit according to claim 1, wherein the current capability of one of the current mirror connected MIS transistors (11, 12; 21, 22) is different from that of the other.

3. A delay circuit according to claim 1 or claim 2, including a switch (13; 23) between a voltage source (Vcc) and the current mirror connected MIS transistors (11, 12; 21, 22), the switch (13; 23) being conductive in response to the input signal being in the second state.

4. A delay circuit according to claim 1, claim 2 or claim 3, wherein each MIS transistor is a PMOS transistor (11, 12; 21, 22), and the gates of both PMOS transistors are connected in common.

5. A delay circuit according to any one of claims 1 to 4, wherein the constant current source is a PMOS transistor (14) to the gate of which the input signal is supplied.

6. A delay circuit according to any one of claims 1 to 4, wherein the constant current source is an NMOS transistor (24) to the gate of which the input signal is supplied through an inverter (29).

7. A delay circuit according to any one of the preceding claims, wherein the discharging means is an NMOS transistor (15; 25) connected in parallel with the capacitance (16; 26).

8. A delay circuit according to any one of the preceding claims, wherein the capacitance (16; 26) is an MOS capacitor.

## Patentansprüche

1. Verzögerungsschaltung zum Erzeugen einer vorgegebenen Zeitverzögerung für eine integrierte Schaltung, wobei die Verzögerungsschaltung umfaßt:
eine Stromspiegelschaltung, welche mindestens ein Paar zu einem Stromspiegel verbundene MIS-Transistoren (11, 12; 21, 22) enthält;
eine Konstantstromquelle (14; 24), welche in dem Strompfad von einem (11; 21) der MIS-Transistoren eingefügt ist;
eine Kapazität (16; 26), welche mit dem anderen (12; 22) der MIS-Transistoren verbunden ist, um durch einen Strom aufgeladen zu werden, der in dem anderen MIS-Transistor (12; 22) fließt; und
eine Einrichtung (15; 25) zum Entladen der Kapazität (16; 26), wobei die Entladungseinrichtung durch ein Eingangssignal bei einem ersten von zwei Zuständen anschaltbar ist;
wodurch die Verzögerungszeit der Verzögerungsschaltung durch die Ladezeit der Kapazität (16; 26) bestimmt wird,
dadurch gekennzeichnet, daß die Konstantstromquelle (14; 24) durch das Eingangssignal bei einem zweiten von zwei Zuständen einschaltbar ist.

2. Verzögerungsschaltung nach Anspruch 1, bei der die Stromleistungsfähigkeit von einem der als Stromspiegel verbundenen MIS-Transistoren (11, 12; 21, 22) verschieden von jener des anderen ist.

3. Verzögerungsschaltung nach Anspruch 1 oder 2, welche einen Schalter (13; 23) zwischen einer Spannungsquelle (Vcc) und den zu einem Stromspiegel verbundenen MIS-Transistoren (11, 12; 21, 22) enthält, wobei der Schalter als Reaktion darauf, daß sich das Eingangssignal im dem zweiten Zustand befindet, leitend wird.

4. Verzögerungsschaltung nach Anspruch 1, 2 oder 3, bei der jeder MIS-Transistor ein PMOS-Transistor (11, 12; 21, 22) ist und die Gates der beiden PMOS-Transistoren gemeinsam verbunden sind.

5. Verzögerungsschaltung nach einem der Ansprüche 1 bis 4, bei der die Konstantstromquelle ein PMOS-Transistor (14) ist, dessen Gate das Eingangssignal zugeführt wird.

6. Verzögerungsschaltung nach einem der Ansprüche 1 bis 4, bei der die Konstantstromquelle ein NMOS-Transistor (24) ist, dessen Gate das Eingangssignal über einen Inverter (29) zugeführt wird.

7. Verzögerungsschaltung nach einem der vorhergehenden Ansprüche, bei der die Entladungseinrichtung ein NMOS-Transistor (15; 25) ist, der parallel zu der Kapazität (16; 26) angeschlossen ist.

8. Verzögerungsschaltung nach einem der vorhergehenden Ansprüche, bei der die Kapazität (16; 26) ein MOS-Kondensator ist.

## Revendications

1. Circuit de retard permettant de produire un retard temporel prédéterminé pour un circuit intégré, le circuit de retard comprenant :
un circuit miroir de courant incluant au moins une paire de transistors MIS connectés en miroir de courant (11, 12 ; 21, 22) ;
une source de courant constant (14 ; 24) connectée dans la voie de courant de l'un (11 ; 21) des transistors MIS ;
une capacité (16 ; 26) connectée à l'autre (12 ; 22) des transistors MIS de manière à être chargée par un courant qui circule dans l'autre transistor MIS (12 ; 22) ; et
un moyen (15 ; 25) pour décharger la capacité (16 ; 26), le moyen de déchargement pouvant être commuté à l'état passant par un signal d'entrée à un premier de deux états,
et ainsi, le retard temporel du circuit de retard est déterminé par le temps de chargement de la capacité (16 ; 26),
caractérisé en ce que la source de courant constant (14 ; 24) peut être commutée à l'état passant par le signal d'entrée à un second des deux états.

2. Circuit de retard selon la revendication 1, dans lequel la capacité de courant de l'un des transistors MIS connectés en miroir de courant (11, 12 ; 21, 22) est différente de celle de l'autre.

3. Circuit de retard selon la revendication 1 ou 2, incluant un commutateur (13 ; 23) entre une source de tension (Vcc) et les transistors MIS connectés en miroir de courant (11, 12 ; 21, 22), le commutateur (13 ; 23) étant conducteur en réponse au signal d'entrée qui est dans le second état.

4. Circuit de retard selon la revendication 1, 2 ou 3, dans lequel chaque transistor MIS est un transistor PMOS (11, 12 ; 21, 22) et les grilles des deux transistors PMOS sont connectées en commun.

5. Circuit de retard selon l'une quelconque des revendications 1 à 4, dans lequel la source de courant constant est un transistor PMOS (14) sur la grille duquel le signal d'entrée est appliqué.

6. Circuit de retard selon l'une quelconque des revendications 1 à 4, dans lequel la source de courant constant est un transistor NMOS (24) sur la grille duquel le signal d'entrée est appliqué par l'intermédiaire d'un inverseur (29).

7. Circuit de retard selon l'une quelconque des revendications précédentes, dans lequel le moyen de déchargement est un transistor NMOS (15 ; 25) connecté en parallèle à la capacité (16 ; 26).

8. Circuit de retard selon l'une quelconque des revendications précédentes, dans lequel la capacité (16 ; 26) est une capacité MOS.
